# EUROPÄISCHE PATENTSCHRIFT

(11) **EP 1 330 152 B1**
(45) Veröffentlichungstag und Bekanntmachung des Hinweises auf die Patenterteilung: **19.07.2006**
(21) Anmeldenummer: 03100084.7
(22) Anmeldetag: 17.01.2003
(51) Int. Cl.: H05K 13/04

(54) **Bestückkopf und Bestückverfahren zum Bestücken von Substraten mit Bauelementen**
Pick-and-place head and method for placing components onto substrates
Tête de pose et procédé de pose de composants sur des substrats

(30) Priorität: 22.01.2002 DE 10202290
(43) Veröffentlichungstag der Anmeldung: 23.07.2003
(73) Patentinhaber: SIEMENS AKTIENGESELLSCHAFT, 80333 München (DE)
(72) Erfinder: Meinzinger, Bruno, 81477, München (DE)

(56) Entgegenhaltungen:
- WO-A-99/31948
- US-A- 5 839 769

## Beschreibung

Bestückkopf und Bestückverfahren zum Bestücken von Substraten mit Bauelementen

Die Erfindung betrifft einen Bestückkopf sowie ein Bestückverfahren zum Bestücken von Substraten mit Bauelementen mittels des Bestückkopfs.

Zum Bestücken von Bauelementen auf Substrate ist eine Vielzahl unterschiedlicher Bestückköpfe bekannt. Beispielsweise gibt es Revolver-Bestückköpfe, bei welchen eine Mehrzahl von Vakuumpipetten rotationssymmetrisch um eine gemeinsame Drehachse angeordnet ist. Das Verfahren des Bestückkopfs über eine Aufnahmeposition zum Aufnehmen der Bauelemente und durch jeweiliges Aufnehmen und anschließendes Drehen um den Winkelabstand zwischen zwei Vakuumpipetten durchgeführt. Daher können mit einem Revolver-Bestückkopf mehrere Bauelemente aufgenommen und anschließend die aufgenommenen Bauelemente an den für sie vorgesehenen Bestückpositionen auf dem zu bestückenden Substrat abgesetzt werden.

Darüber hinaus sind Einzel-Bestückköpfe bekannt, von welchen jeweils ein Bauelement von einer Zuführeinheit entnommen und an seine vorbestimmte Position auf dem Substrat bestückt werden kann. Hierbei muss nach jedem Bauelement die Wegstrecke zwischen dem Substrat und der Zuführeinrichtung zurückgelegt werden.

Ferner sind auch Trommel-Bestückköpfe (Turret-Head) bekannt, bei welchen um eine senkrechte ortsfeste Drehachse eine Mehrzahl von Bestückköpfen umläuft. Meist sind diese umlaufenden Bestückköpfe in einer mechanischen Bewegungs-Kulisse geführt, welche ihre Vertikalbewegung steuert. Das zu bestückende Substrat wird unter einer entlang dem Umfang des Trommel-Bestückkopfs angeordneten Bestückposition bewegt, an welcher die Bauelemente von dem Trommel-Bestückkopf auf das Substrat bestückt werden. Aufgenommen werden die Bauelemente an einer anderen Position entlang des Umfanges des Trommel-Bestückkopfs. Hierbei ist ebenfalls eine Bewegung erforderlich, welche das Zuführen von Bauelementen zu dieser Aufnahmeposition des Trommel-Bestückkopfs ermöglicht.

Darüber hinaus sind noch sogenannte Reihen-Bestückköpfe (Gang-Pick) bekannt, bei welchen eine Mehrzahl von Vakuumpipetten zu einer Reihe angeordnet sind. Von dieser Mehrzahl von Vakuumpipetten kann jeweils ein Bauelement aufgenommen werden. Insbesondere ist es möglich, sämtliche Bauelemente sämtlicher Vakuumpipetten gleichzeitig aufzunehmen. Anschließend wird der gesamte Reihen-Bestückkopf über das Substrat verfahren, wo nacheinander die jeweiligen Bauelemente an ihre vorgesehene Bestückpositionen auf dem Substrat abgesetzt werden.

Innerhalb der Rahmenbedingungen der erforderlichen Leistungssteigerungen auf dem Gebiet der Bestücktechnologie stoßen die bekannten Bestückköpfe jedoch an ihre Leistungsgrenzen. Hierzu trägt auch bei, dass die zu bestückenden Bauelemente immer kleiner werden. Daher werden die Bauelemente von immer geringerer Haltekräften gehalten, da ihre Oberflächen immer kleiner werden, wodurch die entsprechenden Querschnittsflächen der Saugpipetten ebenfalls kleiner werden. Darüber hinaus können auch die mit den geringen Haltekräften gehaltenen Bauelemente nur begrenzt Beschleunigungen ausgesetzt werden.

Aus der Patentschrift US-5 839 769 ist eine Vorrichtung zum Handhaben von Halbleitern während deren Herstellung bekannt, mit mehreren Greifern, welche an einem Träger angeordnet sind und zur Einstellung ihres gegenseitigen Abstands gemeinsam und abhängig voneinander aus Träger verchiebbar sind.

Es ist daher eine Aufgabe der Erfindung, einen Bestückkopf und ein Bestückverfahren zum Bestücken von Substraten mit Bauelementen anzugeben, mittels welchem ein schnelleres und flexibleres Bestücken möglich ist.

Diese Aufgabe wird gelöst durch einen Bestückkopf bzw. ein Bestückverfahren mit den Merkmalen nach den unabhängigen Patentansprüchen. Bevorzugte Ausgestaltungen der Erfindung sind in den abhängigen Ansprüchen beansprucht.

Durch den erfindungsgemäßen Bestückkopf ist es möglich, beispielsweise zwei oder mehr zu bestückende Bauelemente vor dem Bestücken der Bauelemente auf die Substrate die Greifer, von welchen die zu bestückenden Bauelemente gehalten werden, zueinander derart anzuordnen, dass bei einem Aufsetzen des Bestückkopfs auf das zu bestückende Substrat sämtliche an dem Bestückkopf gehaltenen Bauelemente gleichzeitig an die entsprechenden Bestückpositionen abgesetzt werden können. Hierzu weist der erfindungsgemäße Bestückkopf mindestens einen Greifer auf, welcher in der Projektion des Bestückkopfs auf die Bestückebene relativ zu dem Träger ortsfest angeordnet ist, sowie mindestens einen Greifer auf, welcher in der Projektion des Bestückkopfs auf die Bestückebene relativ zu dem Träger innerhalb eines Bewegungsbereiches bewegbar ist.

Bevorzugt sind zusätzlich die Greifer in der Projektionsrichtung bewegbar an dem Träger angebracht. Hierdurch kann zumindest teilweise auf ein Absenken des Bestückkopfs beim Bestücken der Bauelemente auf das zu bestückende Substrat verzichtet werden.

Bevorzugt sind genau ein ortsfester und zwei bewegbare Greifer vorgesehen. Hierbei ist es möglich, den ortsfesten Greifer als Bezugspunkt zu wählen und an diesem die Positionierung der zwei bewegbaren Greifer zu orientieren. Beispielsweise wird beim gleichzeitigen Bestücken von drei Bauelementen, eines an dem ortsfesten Greifer und jeweils eines an den beiden bewegbaren Greifern, die Bestückposition des an dem ortsfesten Greifer gehaltenen Bauelements als Bezugspunkt gewählt. Die beiden bewegbaren Greifer werden entsprechend den jeweiligen Abständen der Bestückpositionen der an den bewegbaren Greifern gehaltenen Bauelemente relativ zu der Bestückposition des an dem ortsfesten Greifer gehaltenen Bauelements in Relation zu dem ortsfesten Greifer positioniert, so dass bei einem Absenken des Bestückkopfs bzw. der Greifer auf das zu bestückende Substrat gleichzeitig alle drei zu bestückenden Bauelemente auf das Substrat an den jeweils vorgesehenen Bestückpositionen bestückt werden können.

Die Greifer können Vakuumgreifer sein. Ferner kann jeweils ein Drehantrieb vorgesehen sein, von welchem die Greifer relativ zu dem Träger drehbar sind. An dem Bestückkopf kann auch ein Wegmeßsystem vorgesehen sein, von welchem der Abstand der Greifer von dem Substrat erfassbar ist.

Erfindungsgemäß ist es auch möglich, vor dem Bestücken die Abfolge jener Positionen festzulegen, an welche der Bestückkopf während des Bestückverfahrens relativ zu der Bestückebene verfahren wird. Hierbei werden die Positionen des Bestückkopfs derart festgelegt, dass jeweils der ortsfeste Greifer sowie möglichst viele der innerhalb des Bewegungsbereiches bewegbaren Greifer über entsprechenden Bestückpositionen positioniert werden können. Hierdurch wird eine maximale Bestückleistung bei hoher Flexibilität ermöglicht. Es ist hierzu beispielsweise möglich, ein Abbild des Bewegungsbereiches der bewegbaren Greifer des Bestückkopfs zu bilden und dieses einem Abbild der mit Bauelementen zu bestückenden Positionen auf dem Substrat zu überlagern. Bei einer derartigen Überlagerung kann erkannt werden, mit welchen der bewegbaren Greifer jeweils ein Bauelement auf das zu bestückende Substrat bestückt werden könnte, wenn mit dem ortsfesten Greifer ein Bauelement bestückt wird.

Bei der Durchführung dieser Optimierung kann beispielsweise das Abbild des Bewegungsbereiches der bewegbaren Greifer relativ zu dem Abbild der mit Bauelementen zu bestückenden Positionen des Substrats bewegt werden und bei entsprechender Übereinstimmung des Bewegungsbereiches der bewegbaren Greifer mit einer mit Bauelementen zu bestückenden Position auf dem Substrat gespeichert werden. Anschließend werden beispielsweise sämtliche in diesem Bestückschritt zu bestückenden Bauelemente aus dem Abbild der mit Bauelementen zu bestückenden Positionen auf dem Substrat entfernt und die Analyse für die verbleibenden zu bestückenden Bauelemente erneut durchgeführt. Als Kriterium für die nächste anzusteuernde Bestückposition kann gemäß dem Nearest-Neighbour-Prinzip vorgegangen werden, d. h. es wird versucht, die naheliegendste Bestückposition zu erreichen, an welcher möglichst viele Bauelemente bestückt werden können.. Dies ist hierbei nicht zwingend die von der vorherigen Bestückposition ausgehend naheliegendste Bestückposition, sondern jene, bei welcher unter Berücksichtigung der Verfahrwege, welche erforderlich sind, um neue Bauelemente aufzunehmen, den geringsten Gesamtweg des Bestückkopfs erfordert.

Es ist auch möglich, das erfindungsgemäße Verfahren sinngemäß zum Abholen von Bauelementen aus entsprechenden Zuführeinrichtungen zu verwenden. Hierbei treten lediglich an die entsprechenden Bestückpositionen auf dem Substrat diejenigen Abholpositionen an den Zuführeinrichtungen, an welchen die Bauelemente zum Entnehmen bereitgestellt werden. Ansonsten gelten für das Aufnehmen von Bauelementen entsprechend der Erfindung sinngemäß die gleichen Voraussetzungen wie für das Bestücken.

Die Erfindung wird nachfolgend unter Bezugnahme auf die Zeichnung näher erläutert. In der Zeichnung zeigen
Figur 1 eine schematische Draufsicht auf einen Bestückkopf nach einer erfindungsgemäßen Ausführungsform;
Figur 2 eine schematische perspektivische Ansicht des Bestückkopfs nach der bevorzugten Ausführungsform der Erfindung über einer Bestückebene;
Figur 3 eine schematische Ansicht eines Abbilds des Bewegungsbereichs der Greifer des Bestückkopfs nach der bevorzugten Ausführungsform.

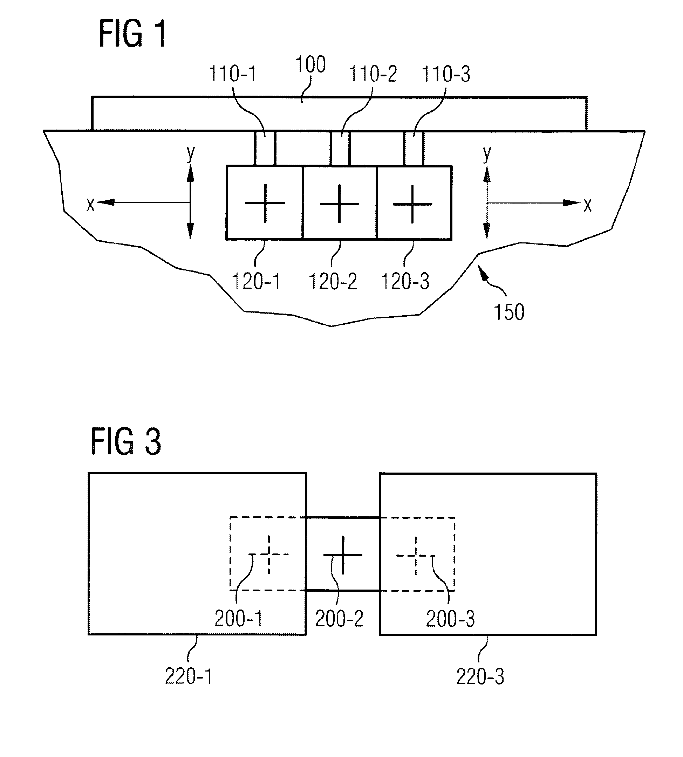

Wie aus Figur 1 ersichtlich, weist der erfindungsgemäße Bestückkopf 150 einen Träger 100 sowie mehrere Greifer 120 auf. Die Greifer sind jeweils über eine Lagervorrichtung 110 mit dem Träger verbunden. Erfindungsgemäß sind zum Erreichen eines optimalen Bestückergebnisses unterschiedliche Greifer an dem Träger 100 angebracht. Der mittlere Greifer 120-2 ist in Bezug auf den Träger 100 in der Projektionsrichtung auf die Bestückebene (in der Zeichnung die Zeichenebene) ortsfest relativ zu dem Träger 100 angebracht. Daher kann der ortsfeste Greifer 120-2 mittels einer starren Lagervorrichtung 110-2 an dem Träger 100 angebracht sein.

Die beiden seitlich des ortsfesten Greifers 120-2 angebrachten Greifer 120-1 bzw. 120-3 sind in der Projektionsrichtung des Bestückkopfs 150 auf die Bestückebene relativ zu dem Träger 100 bewegbar angeordnet. Wie aus der Figur 1 durch die Pfeile ersichtlich, sind die beiden seitlichen Greifer 120-1 und 120-3 sowohl in der X-Richtung als auch in der Y-Richtung bewegbar ausgebildet. Daher sind sie mit für entsprechende Bewegungen geeigneten Lagervorrichtungen 110-1 bzw. 110-3 an dem Träger 100 angebracht.

Um die Relativbewegung der seitlichen Greifer 120-1 und 120-3 relativ zu dem Träger 100 bewerkstelligen zu können, sind an dem erfindungsgemäßen Bestückkopf 150 beispielsweise Antriebe vorgesehen. Die Antriebe können im Träger 100 untergebracht und/oder in oder an den seitlichen Greifern 120-1 und 120-3 angebracht sein.

Als Lagervorrichtungen 110-1 und 110-3 für die seitlichen Greifer 120-1 bzw. 120-3 kommen sowohl X- Y-Portale als auch magnetische Flächenlager oder andere für eine Lagerung in X- und Y-Richtung geeignete Lager in Frage.

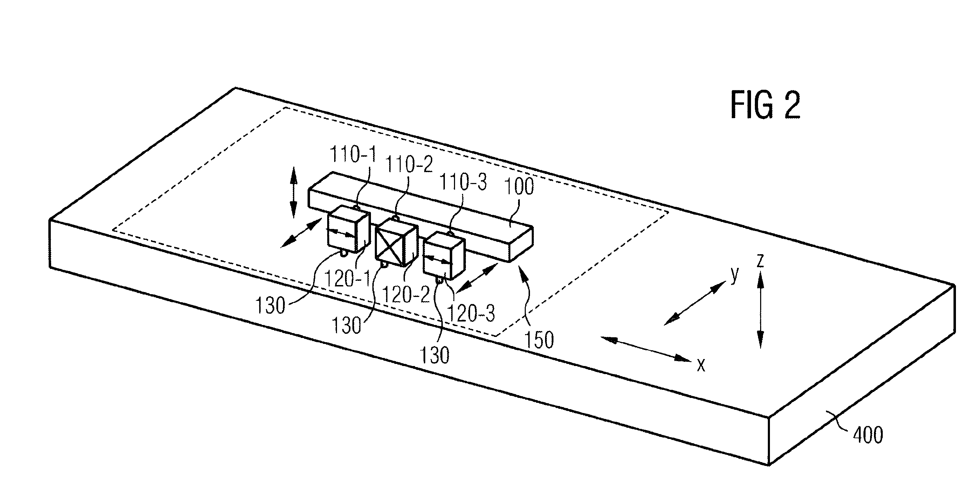

Aus Figur 2 ist eine schematische perspektivische Ansicht der bevorzugten Ausführungsform des erfindungsgemäßen Bestückkopfs 150 über einer Bestückebene 400 dargestellt.

Dabei kann der erfindungsgemäße Bestückkopf 150 mit dem Träger 100 und den Greifern 120 beispielsweise von einem X-Y-Portalantrieb in der X- und in der Y-Richtung über der Bestückebene 400 bewegt werden. Die Bewegung im Wesentlichen senkrecht zu der Bestückebene kann beispielsweise durch einen entsprechenden Z-Antrieb, welcher an dem Träger 100 angreift, vorgesehen sein. Es ist auch möglich, die jeweilige Bewegung in der Z-Richtung durch individuelle Antriebe in den Greifern 120 zu ermöglichen. Es ist auch möglich, an den Greifern vorgesehene Vakuum-Pipetten 130 für die Bewegung in der Z-Richtung einzeln absenkbar und anhebbar auszubilden. Hierfür können beispielsweise Hub-Dreh-Antriebe verwendet werden.

Aus Figur 3 ist eine schematische Ansicht des Bewegungsbereiches der bewegbaren Greifer des erfindungsgemäßen Bestückkopfs 150 in Anlehnung an die Darstellung der Greifer 120 des erfindungsgemäßen Bestückkopfs 150 aus Figur 1 ersichtlich. Dabei ist für jeden Bestückkopf 150 eine entsprechende Markierung 200-1, 200-2 bzw. 200-3 vorgesehen, welche die Ruhelage des jeweiligen Greifers 120-1, 120-2 bzw. 120-3 darstellt.

Der mittlere, ortsfeste Greifer 120-2 bildet die Grundlage für den mittleren Bezugspunkt 200-2, welcher in dem Abbild des Bewegungsbereiches der Greifer des erfindungsgemäßen Bestückkopfs 150 festliegt. Links und rechts seitlich des Bezugspunktes 200-2 des ortsfesten Greifers 120-2 sind jeweils die Bewegungsbereiche 220-1, 220-3 der bewegbaren Greifer 120-1 bzw. 120-3 dargestellt. Die bewegbaren Greifer 120-1 und 120-3 können jeweils in der Ebene parallel zur Bestückebene (hier die Zeichenebene) relativ zu dem ortsfesten Greifer 120-2 bewegt werden.

Um einen optimierten Bestückablauf mit dem erfindungsgemäßen Bestückkopf 150 durchführen zu können, wird nun das Abbild des Bewegungsbereiches der Greifer 120 über ein Abbild der mit Bauelementen zu bestückenden Positionen auf dem zu bestückenden Substrat überlagert. Hierbei wird zunächst eine zu bestückende Position auf dem Substrat mit dem Bezugspunkt 200-2 des ortsfesten Greifers 120-2 anvisiert, so dass mittels des ortsfesten Greifers 120-2 ein Bauelement an dieser Position abgesetzt werden könnte. Im Anschluss daran kann festgestellt werden, an welche anderen Bestückpositionen gleichzeitig mit den bewegbaren Greifern 120-1 und 120-3 Bauelemente positioniert werden könnten. Diese zu bestückenden Positionen müssen, während mittels des Bezugspunktes 200-2 die eine zu bestückende Position anvisiert wird, innerhalb der Bewegungsbereiche 220-1 bzw. 220-3 der bewegbaren Greifer 120-1 bzw. 120-3 liegen.

Nach einem derartigen Durchlauf wird das Abbild der mit Bauelementen zu bestückenden Positionen entsprechend markiert und/oder korrigiert, um die bereits berücksichtigten zu bestückenden Positionen kenntlich zu machen, so dass diese nicht ein zweites Mal anvisiert werden können. Daraufhin wird die Optimierung erneut durchgeführt, bis alle zu bestückenden Positionen berücksichtigt wurden.

Nachdem die Optimierung durchgeführt wurde, wird das Bestücken der Bauelemente in der mittels der Optimierung festgelegten Reihenfolge durchgeführt.

## Patentansprüche

1. Bestückkopf für ein Bestücksystem zum Bestücken von Bauelementen auf eine Bestückebene (400) zu bestückender Substrate, der Bestückkopf (150) mit
• einem Träger (100), welcher relativ zu der Bestückebene (400) bewegbar ist,
• mindestens einem in der Projektion des Bestückkopfs (150) auf die Bestückebene (400) relativ zu dem Träger (100) ortsfesten Greifer (120-2), und
• mindestens einem in der Projektion des Bestückkopfs (150) auf die Bestückebene (400) relativ zu dem Träger (100) innerhalb eines Bewegungsbereichs bewegbaren Greifer (120-1, 120-3)

2. Bestückkopf nach Anspruch 1, wobei
• die Greifer (120-1, 120-2, 120-3) in der Projektionsrichtung bewegbar an dem Träger (100) angebracht sind.

3. Bestückkopf nach einem der Ansprüche 1 oder 2, wobei genau ein ortsfester Greifer (120-2) und zwei bewegbare Greifer (120-1, 120-3) vorgesehen sind.

4. Bestückkopf nach einem der Ansprüche 1 bis 3, wobei die Greifer (120-1, 120-2, 120-3) Vakuumgreifer sind.

5. Bestückkopf nach einem der vorangehenden Ansprüche, wobei ein Drehantrieb vorgesehen ist, von welchem die Greifer (120-1, 120-2, 120-3) relativ zu dem Träger (100) drehbar sind.

6. Bestückkopf nach einem der vorangehenden Ansprüche, wobei an dem Bestückkopf (150) ein Wegmeßsystem vorgesehen ist, von welchem der Abstand der Greifer (120-1, 120-2, 120-3) von dem Substrat erfassbar ist.

7. Bestückverfahren zum Bestücken von Substraten mit Bauelementen mittels eines Bestückkopfs (150) nach einem der Ansprüche 1 bis 6, wobei
• der Träger (100) über dem Substrat derart verfahren wird, dass der ortsfeste Greifer (120-2) über eine Bestückposition für ein an dem ortsfesten Greifer (120-2) aufgenommenes Bauelement positioniert wird,
• die bewegbaren Greifer (120-1, 120-3) relativ zu dem Träger derart bewegt werden, dass sie über jeweiligen Bestückpositionen für an den bewegbaren Greifern (120-1, 120-3) aufgenommene Bauelemente positioniert werden, welche bezüglich der Bestückposition des ortsfesten Greifers (120-2) im Bewegungsbereich der bewegbaren Greifer (120-1, 120-3) liegen,
• unter Absenken des Trägers (100) und/oder Absenken der Greifer (120-1, 120-2, 120-3) gleichzeitig an der Bestückposition des ortsfesten Greifers (120-2) und an den Bestückpositionen der bewegbaren Greifer (120-1, 120-3) Bauelemente gleichzeitig auf das Substrat bestückt werden.

8. Bestückverfahren nach Anspruch 7, wobei
• vor dem Bestücken die Abfolge der Positionen, an welche der Bestückkopf (150) relativ zu der Bestückebene (400) verfahren wird, festgelegt wird, wobei
• die Positionen des Bestückkopfs (150) derart festgelegt werden, dass jeweils der ortsfeste Greifer (120-2) sowie möglichst viele der innerhalb des Bewegungsbereichs bewegbaren Greifer (120-1, 120-3) über einer entsprechenden Bestückposition positioniert werden können.

9. Bestückverfahren nach Anspruch 8, wobei
• beim Festlegen der Positionen des Bestückkopfs (150) ein Abbild des Bewegungsbereichs der bewegbaren Greifer des Bestückkopfs (150) einem Abbild (220-1, 220-3)der mit Bauelementen zu bestückenden Positionen auf dem Substrat überlagert wird.

10. Bestückverfahren nach Anspruch 9, wobei
• das überlagerte Abbild (220-1, 220-3) relativ zu dem Abbild der mit Bauelementen zu bestückenden Positionen auf dem Substrat bewegt wird.

11. Bestückverfahren nach einem der Ansprüche 7 bis 10, wobei vor dem Bestücken
- der Träger (100) über Zuführeinrichtungen derart verfahren wird, dass der ortsfeste Greifer (120-2) über einer Abholposition für ein von dem ortsfesten Greifer (120-2) aufzunehmenden Bauelement positioniert wird,
- die bewegbaren Greifer (120-1, 120-3) relativ zu dem Träger derart bewegt werden, dass sie über jeweiligen Abholpositionen für die von den bewegbaren Greifer (120-1, 120-3) aufzunehmenden Bauelemente positioniert werden, welche bezüglich der Abholposition des ortsfesten Greifers (120-2) im Bewegungsbereich der bewegbaren Greifer (120-1, 120-3) liegen,
- unter Absenken des Trägers (100) und/oder Absenken der Greifer (120-1, 120-2, 120-3) gleichzeitig an der Abholposition des ortsfesten Greifers (120-2) und an den Abholpositionen der bewegbaren Greifer (120-1, 120-3) Bauelemente gleichzeitig von der Zuführeinrichtungen aufgenommen werden.

## Claims

1. Pick-and-place head for a pick-and-place system for placing components onto a placement plane (400) of substrates that are to be loaded, said pick-and-place head (150) comprising
• a carrier (100) which is movable relative to the placement plane (400),
• at least one stationary gripper (120-2) in the projection of the pick-and-place head (150) onto the placement plane (400) relative to the carrier (100), and
• at least one movable gripper (120-1, 120-3) in the projection of the pick-and-place head (150) onto the placement plane (400) relative to the carrier (100) within a movement range.

2. Pick-and-place head according to claim 1, wherein
• the grippers (120-1, 120-2, 120-3) are attached to the carrier (100) movably in the projection direction.

3. Pick-and-place head according to one of the claims 1 or 2, wherein precisely one stationary gripper (120-2) and two movable grippers (120-1, 120-3) are provided.

4. Pick-and-place head according to one of the claims 1 to 3, wherein the grippers (120-1, 120-2, 120-3) are vacuum grippers.

5. Pick-and-place head according to one of the preceding claims, wherein a rotary drive is provided by which the grippers (120-1, 120-2, 120-3) can be rotated relative to the carrier (100).

6. Pick-and-place head according to one of the preceding claims, wherein there is provided at the pick-and-place head (150) a distance measuring system by which the distance of the grippers (120-1, 120-2, 120-3) from the substrate can be recorded.

7. Placement method for placing components onto substrates by means of a pick-and-place head (150) according to one of the claims 1 to 6, wherein
• the carrier (100) is moved over the substrate in such a way that the stationary gripper (120-2) is positioned over a placement position for a component picked by the stationary gripper (120-2),
• the movable grippers (120-1, 120-3) are moved relative to the carrier in such a way that they are positioned over respective placement positions for components picked by the movable grippers (120-1, 120-3), said components lying in the movement range of the movable grippers (120-1, 120-3) in relation to the placement position of the stationary gripper (120-2),
• components are placed onto the substrate simultaneously as the carrier (100) and/or the grippers (120-1, 120-2, 120-3) are lowered simultaneously at the placement position of the stationary gripper (120-2) and at the placement positions of the movable grippers (120-1, 120-3).

8. Placement method according to claim 7, wherein
• the sequence of the positions to which the pick-and-place head (150) is moved relative to the placement plane (400) is defined prior to the placement, with
• the positions of the pick-and-place head (150) being specified in such a way that in each case the stationary gripper (120-2) and as many as possible of the movable grippers (120-1, 120-3) within the movement range can be positioned over a corresponding placement position.

9. Placement method according to claim 8, wherein
• when the positions of the pick-and-place head (150) are specified, a map of the movement range of the movable grippers of the pick-and-place head (150) is overlaid on a map (220-1, 220-3) of the positions on the substrate that are to be loaded with components.

10. Placement method according to claim 9, wherein
• the overlaid map (220-1, 220-3) is moved relative to the map of the positions on the substrate that are to be loaded with components.

11. Placement method according to one of the claims 7 to 10, wherein, prior to the placement,
- the carrier (100) is moved over feeder devices in such a way that the stationary gripper (120-2) is positioned over a pick position for a component that is to be picked by the stationary gripper (120-2),
- the movable grippers (120-1, 120-3) are moved relative to the carrier in such a way that they are positioned over respective pick positions for the components that are to be picked by the movable grippers (120-1, 120-3), said components lying in the movement range of the movable grippers (120-1, 120-3) in relation to the pick position of the stationary gripper (120-2),
- components are picked from the feeder devices simultaneously as the carrier (100) and/or the grippers (120-1, 120-2, 120-3) are lowered simultaneously at the pick position of the stationary gripper (120-2) and at the pick positions of the movable grippers (120-1, 120-3).

## Revendications

1. Tête de pose pour un système de pose permettant de poser des composants sur un plan de pose (400) de substrats à garnir, la tête de pose (150) comprenant
• un support (100) qui peut être déplacé par rapport au plan de pose (400),
• au moins un élément preneur (120-2) fixe par rapport au support (100) dans la projection de la tête de pose (150) sur le plan de pose (400) et
• au moins un élément preneur (120-1, 120-3) mobile par rapport au support (100) à l'intérieur d'une zone de déplacement dans la projection de la tête de pose (150) sur le plan de pose (400).

2. Tête de pose selon la revendication 1,
• les éléments preneurs (120-1, 120-2, 120-3) étant montés sur le support (100) mobiles dans la direction de projection.

3. Tête de pose selon l'une des revendications 1 ou 2, exactement un élément preneur fixe (120-2) et deux éléments preneurs mobiles (120-1, 120-3) étant prévus.

4. Tête de pose selon l'une des revendications 1 à 3, les éléments preneurs (120-1, 120-2, 120-3) étant des éléments preneurs à vide.

5. Tête de pose selon l'une des revendications précédentes, une commande rotative permettant aux éléments preneurs (120-1, 120-2, 120-3) d'effectuer une rotation par rapport au support (100) étant prévue.

6. Tête de pose selon l'une des revendications précédentes, un système de mesure de déplacement étant prévu sur la tête de pose (150), grâce auquel la distance entre les éléments preneurs (120-1, 120-2, 120-3) et le substrat peut être saisie.

7. Procédé de pose pour poser des composants sur des substrats au moyen d'une tête de pose (150) selon l'une des revendications 1 à 6,
• le support (100) étant déplacé au-dessus du substrat de manière à ce que l'élément preneur fixe (120-2) soit positionné au-dessus d'une position de pose prévue pour un composant saisi sur l'élément preneur fixe (120-2),
• les éléments preneurs mobiles (120-1, 120-3) étant déplacés par rapport au support de manière à être positionnés au-dessus de positions de pose respectives prévues pour des composants saisis sur les éléments preneurs mobiles (120-1, 120-3), lesquelles positions se situent dans la zone de déplacement des éléments preneurs mobiles (120-1, 120-3) par rapport à la position de pose de l'élément preneur fixe (120-2),
• des composants étant posés simultanément sur le substrat sous l'abaissement du support (100) et/ou des éléments preneurs (120-1, 120-2, 120-3) simultanément au niveau de la position de pose de l'élément preneur fixe (120-2) et au niveau des positions de pose des éléments preneurs mobiles (120-1, 120-3).

8. Procédé de pose selon la revendication 7,
• la succession des positions au niveau desquelles la tête de pose (150) est déplacée par rapport au plan de pose (400) étant déterminée avant la pose,
• les positions de la tête de pose (150) étant déterminées de manière à ce que l'élément preneur fixe (120-2) ainsi que le plus grand nombre possible des éléments preneurs (120-1, 120-3) mobiles à l'intérieur de la zone de déplacement puissent être positionnés à chaque fois au-dessus d'une position de pose correspondante.

9. Procédé de pose selon la revendication 8,
• une représentation de la zone de déplacement des éléments preneurs mobiles de la tête de pose (150) étant superposée, lors de la détermination des positions de la tête de pose (150), à une représentation (220-1, 220-3) des positions à garnir de composants sur le substrat.

10. Procédé de pose selon la revendication 9,
• la représentation superposée (220-1, 220-3) étant déplacée par rapport à la représentation des positions à garnir de composants sur le substrat.

11. Procédé de pose selon l'une des revendications 7 à 10,
- le support (100) étant déplacé au-dessus de dispositifs d'alimentation, avant la pose, de manière à ce que l'élément preneur fixe (120-2) soit positionné au-dessus d'une position de prélèvement pour un composant devant être saisi par l'élément preneur fixe (120-2),
- les éléments preneurs mobiles (120-1, 120-3) étant déplacés par rapport au support, avant la pose, de manière à être positionnés au-dessus de positions d'enlèvement respectives pour les composants devant être saisis par les éléments preneurs mobiles (120-1, 120-3), lesquelles positions se trouvent dans la zone de déplacement des éléments preneurs mobiles (120-1, 120-3) par rapport à la position d'enlèvement de l'élément preneur fixe (120-2),
• - des composants étant saisis simultanément sur les dispositifs d'alimentation, avant la pose, sous l'abaissement du support (100) et/ou des éléments preneurs (120-1, 120-2, 120-3) simultanément au niveau de la position d'enlèvement de l'élément preneur fixe (120-2) et au niveau des positions d'enlèvement des éléments preneurs mobiles (120-1, 120-3).
